Europäisches Patentamt

European Patent Office

Office européen des brevets

(19)

(11) Veröffentlichungsnummer : **0 095 564**
**B1**

# (12) EUROPÄISCHE PATENTSCHRIFT

(45) Veröffentlichungstag der Patentschrift :
**02.01.86**

(21) Anmeldenummer : **83102639.8**

(22) Anmeldetag : **17.03.83**

(51) Int. Cl.⁴ : **H 03 J 1/04,** H 03 J 7/18

(54) **Ortsveränderlicher Rundfunkempfänger, wie Autoradio oder dergl.**

(30) Priorität : **29.05.82 DE 3220428**

(43) Veröffentlichungstag der Anmeldung :
**07.12.83 Patentblatt 83/49**

(45) Bekanntmachung des Hinweises auf die Patenterteilung : **02.01.86 Patentblatt 86/01**

(84) Benannte Vertragsstaaten :
**AT CH FR GB IT LI SE**

(56) Entgegenhaltungen :
**DE-A- 2 746 186**
**DE-A- 2 850 733**
**DE-A- 2 850 866**
**DE-A- 2 903 944**
**DE-A- 3 031 527**
**FUNKSCHAU, Band 50, Nr. 18, August 1978, Seiten 886-888, München, DE. W. HENZE: "Mikroprozessor steuert UKW-Empfänger"**

(73) Patentinhaber : **Blaupunkt-Werke GmbH**
**Robert-Bosch-Strasse 200**
**D-3200 Hildesheim (DE)**

(72) Erfinder : **Strauss, Karl-Peter, Dipl.-Ing.**
**Lachnerring 26**
**D-3200 Hildesheim (DE)**

(74) Vertreter : **Eilers, Norbert, Dipl.-Phys.**
**Blaupunkt-Werke GmbH Robert-Bosch-Strasse 200**
**D-3200 Hildesheim (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft einen ortsveränderlichen Rundfunkempfänger, wie Autoradio oder dergleichen, insbesondere einen UKW-Empfänger, der im Oberbegriff des Anspruchs 1 angegebenen Gattung.

Ein derartiger Rundfunkempfänger ist beispielsweise in der DE-A-2 850 733 beschrieben. Bei einem Rundfunkempfänger dieser Art braucht der Bedienende zur Anwahl der verschiedenen Programme einer Sendeanstalt nicht mehr — wie häufig noch üblich — die Sendefrequenzen der die Programme ausstrahlenden Sender aufzusuchen, einzustellen oder gar abzustimmen. Vielmehr werden die empfangbaren Sendeanstalten und deren Programme im Bedienfeld des Rundfunkempfängers angezeigt. Der Bedienende kann durch einfachen Knopf- oder Tastendruck die Sender in direkter Weise erreichen, ohne Frequenzen, Kanäle, Sendeorte oder Sendeleistungen kennen zu müssen. Nach Eingabe eines im Bedienfeld angezeigten gewünschten Programms wird dieses selbsttätig aufgesucht, eingestellt und wiedergegeben.

Auf dem Bedienfeld sind dabei alle Sendeanstalten mit ihren Programmen angezeigt, die in einem vorgegebenen Sendegebiet, zum Beispiel in der Bundesrepublik Deutschland, üblicherweise empfangen werden können. Bei dem großen Angebot an Sendeanstalten und Programmen bedeutet dies ein umfangreiches Bedienfeld mit einer Vielzahl von Programmanzeigeflächen für die einzelnen Programme, die dem Bedienenden zur Auswahl zur Verfügung stehen. Allerdings muß dabei in Kauf genommen werden, daß je nach momentanem Standort des in einem Fahrzeug installierten Rundfunkempfängers ein Teil der angebotenen Programme nicht oder nur mit relativ schlechter Empfangsqualität empfangen werden kann, weil die Entfernung des Rundfunkempfängers zu Sendern, die diese Programme abstrahlen, größer als die übliche Senderreichweite ist. Somit werden einerseits eine Vielfalt von Programmen angeboten, die teilweise gar nicht empfangen werden können. Andererseits lenkt gerade diese Vielfalt des Programmangebots den Fahrer eines Fahrzeuges im Moment der Programmauswahl zu sehr und vor allem zu lange von dem Verkehrsgeschehen ab, was sowohl die eigene als auch die Sicherheit andere Verkehrsteilnehmer nicht unerheblich beeinträchtigt. Hinzu kommt bei der Auswahl eines nicht empfangbaren Programms die Notwendigkeit der erneuten Programmauswahl und Programmanwahl, so daß ein erneuter Ablenkungseffekt gegeben ist.

Aus der Zeitschrift « Funkschau », Band 50, Nr.18, August 1978, Seiten 886 bis 888, München, DE, ist ein Empfänger bekannt, bei dem nach der Eingabe eines Teiles der Postleitzahl des Standortes des Empfängers, die für den Empfang in der betreffenden Region in Betracht kommenden Sendeanstalten angezeigt werden, und zwar durch schwaches Aufleuchten ihrer Namen auf einer Anzeige, deren Spalten jeweils Sensortasten zugeordnet sind.

Der Erfindung liegt die Aufgabe zugrunde, einen Rundfunkempfänger, insbesondere ein Autoradio, der eingangs genannten Art derart zu verbessern, daß abhängig von dem momentanen Standort des ortsveränderlichen Rundfunkempfängers dem Bedienenden im Bedienfeld nur eine kleine Gruppe von Sendeanstalten mit ihren Programmen zur Auswahl angeboten wird, deren Sender am momentanen Empfangsort des Fahrzeuges auch tatsächlich und vorzugsweise mit optimaler Empfangsqualität empfangen werden können.

Die Aufgabe ist bei einem ortsveränderlichen Rundfunkempfänger der im Oberbegriff des Anspruchs 1 definierten Gattung erfindungsgemäß durch die Merkmale im kennzeichnenden Teil des Anspruchs 1 gelöst.

Bei dem erfindungsgemäßen Rundfunkempfänger werden dem Bedienenden immer nur eine kleine Gruppe, z. B. fünf, empfangbarer Programme zur Auswahl angeboten. Das Bedienfeld mit den Programmanzeigeflächen ist klein und leicht überschaubar. Das Ablesen der empfangbaren Programme, die von vom Empfänger selbsttätig identifizierten Sendern abgestrahlt werden, kann schnell mit einem einzigen Blick erfolgen und benötigt nur kurz die Aufmerksamkeit des Bedienenden, so daß bei der Verwendung des Rundfunkempfängers als Autoradio der Fahrer eines Fahrzeugs nicht unzulässig lange vom Verkehrsgeschehen abgehalten wird. Bei einem einmal ausgesuchten Programm kann der Bedienende absolut sicher sein, daß er dieses Programm mit optimaler Qualität empfangen kann. Ein wiederholtes Programmaussuchen mit dem damit verbundenen Ablenkungseffekt vom Verkehrsgeschehen wegen Auswahl nicht empfangbarer Programme wird vermieden.

Vorteilhafte Ausgestaltungen der Erfindung ergeben sich aus den weiteren Ansprüchen. Eine besonders zweckmäßige Ausführungsform der Erfindung ist dabei in Anspruch 7 angegeben. Durch den sogenannten Zweitempfänger, der Senderidentifikationsvorrichtung und der Empfangsqualitäts-Kontrollvorrichtung wird automatisch aus der Menge der am Standort des Rundfunkempfängers empfangbarer Sender mit verschiedenen Programmen in dem Bedienfeld die ausgewählte Gruppe von verschiedenen Programmen angezeigt, die von den am Standort des Rundfunkempfängers empfangsstärksten Sendem der einzelnen Sendeanstalten abgestrahlt werden.

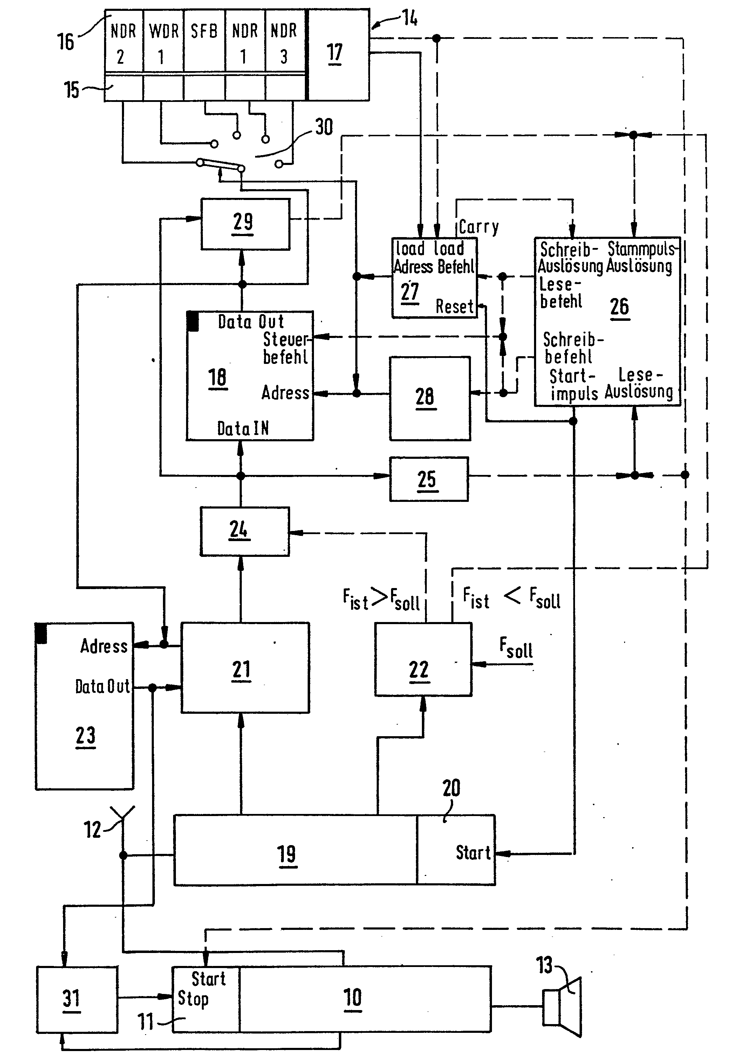

Die Erfindung ist anhand eines in der Zeichnung dargestellten Ausführungsbeispiels im folgenden näher beschrieben. Dabei zeigt die Zeichnung im Blockschaltbild den Schaltungsaufbau eines Autoradios mit Programm-Direktwahl.

Das als UKW-Empfänger ausgebildete Autoradio mit einer Einrichtung zur Programmdirektwahl weist einen Empfangsteil 10 mit Durchlaufautomatik 11 auf. Wie bekannt, enthält dieser Empfangsteil 10 den Zwischenfrequenzteil, den Oszillatorkreis, den Demodulator und den Niederfrequenzteil. Mit 12 ist die Antenne und mit 13 der an dem Niederfrequenzteil angeschlossene Lautsprecher bezeichnet. Unter Durchlaufautomatik 11 wird hier eine Einrichtung verstanden, die bei Programmanwahl in Tätigkeit gesetzt wird und den Empfangsteil 10 durchstimmt, bis sie auf ein Stopsignal hin stillgesetzt wird.

Das Autoradio weist ein Bedienfeld 14 auf, das vorzugsweise als Tastatur ausgebildet ist. Das Bedienfeld 14 weist eine Vielzahl von Anwahlgliedern 15 in Form von Eingabetasten auf. Jedem Anwahlglied 15 ist eine Programmanzeigefläche 16 zugeordnet, auf welcher in übersichtlicher Weise die Sendeanstalt mit ihrem Sendeprogramm angezeigt ist. Mittels des Anwahlglieds 15 kann das auf der Programmanzeigefläche 16 angezeigte Programm gewählt werden, das dann automatisch im Autoradio eingestellt wird. Mit den Anwahlgliedern 15 ist ein Befehlsdecoder 17 gekoppelt, der das bei Drücken eines Anwahlgliedes 15 ausgegebene codierte Steuersignal in eine Adressvorgabe für einen noch zu beschreibenden Speicheradressierer umwandelt. Die Programmanzeigeflächen 16 sind mit veränderbaren Programmanzeigen belegbar. In dem in der Zeichnung dargestellten Beispiel sind z. B. die Programme 1, 2 und 3 der Sendeanstalt NDR, das Programm 1 der Sendeanstalt WDR und die Sendeanstalt SFB angezeigt. Diese angezeigten Programme geben eine aktuelle Auswahl derjenigen Programme wieder, die von Sendern abgestrahlt werden, deren Empfangsqualität am momentanen Standort des Autoradios einem vorgegebenen Empfangskriterium genügt. Das vorgegebene Empfangskriterium kann dabei z. B. eine vorbestimmte Empfangsfeldstärke sein. Damit werden nur solche Programme und Sendeanstalten im Bedienfeld 14 zur Auswahl angeboten, deren Sender am Empfangsort eine ausreichend hohe Empfangsfeldstärke besitzen.

Zur Zuordnung von Programmanzeigeflächen 16 und Anwahlgliedern 15 ist ein Koppelspeicher 18 vorgesehen, der als Schreib- Lese- Speicher mit wahlfreiem Zugriff (RAM) ausgebildet ist. Jede Programmanzeigefläche 16 mit dem zugehörigen Programmanwahlglied 15 ist einem Speicherplatz des Koppelspeichers 18 fest zugeordnet. In dem Koppelspeicher sind Senderbestimmungsgrößen derjenigen Sender abgespeichert, die dem vorgegebenen Empfangskriterium genügen.

Zum Belegen des Koppelspeichers 18 mit Senderbestimmungsgrößen der am Empfängerort empfangbaren Sender, die dem vorbestimmten Empfangskriterium genügen, und zur laufenden Aktualisierung des Speicherinhalts in Anpassung an den wechselnden Empfängerort ist eine Schaltung erforderlich, deren wesentliche Komponenten ein zweiter Empfangsteil 19 mit Suchlaufautomatik 20 zum permanenten Aufsuchen empfangbarer Sender, eine Senderidentifikationsvorrichtung 21 zum Identifizieren des jeweils aufgefundenen Senders und eine Empfangsqualitäts-Kontrollvorrichtung 22 zum Prüfen der Empfangsqualität des jeweils aufgefundenen Senders sind. Die Empfangsqualität-Kontrollvorrichtung 22 ist hier als einfacher Feldstärkenvergleicher ausgebildet, dem einerseits die Feldstärke des gerade im zweiten Empfangsteil 19 empfangenen Senders und andererseits eine Soll-Feldstärke zugeführt wird. Die Senderidentifikationsvorrichtung 21 identifiziert den im zweiten Empfangsteil 19 gerade eingestellten Sender anhand von Zusatzinformationen, die von dem Sender ausgestrahlt werden und charakteristisch für diesen sind. Ein Verfahren zur Übertragung von Zusatzinformationen und zur Auswertung dieser mittels einer Senderidentifikationsvorrichtung 21 ist in dem technischen Bericht Nr. 10/1979 des Instituts für Rundfunktechnik IRT « Untersuchung eines Verfahrens zur Übertragung von Zusatzinformationen im FM-Hörrundfunk » beschrieben. Es ist auch möglich, einen im Empfangsteil 19 eingestellten und empfangenen Sender mittels seiner Sendefrequenz und einer Bereichskennung zu identifizieren, die von sogenannten ARI-Sendern, also von Rundfunksendern mit Autofahrerinformation, abgestrahlt werden. Eine solche Identifizierung eines Senders anhand der Sendefrequenz und Bereichskennung (BK) ist in der DE-OS-2 850 733 beschrieben. Im ersten Fall werden somit der Senderidentifikationsvorrichtung 21 eine für den im Empfangsteil 19 empfangenen Sender charakteristische Zusatzinformation und im zweiten Fall die Sendefrequenz und die zugehörige Bereichskennung zugeführt. Die Senderidentifikationsvorrichtung 21 ist andererseits mit einem Senderspeicher 23 gekoppelt, in welchem die Sendeanstalten, ihre zugehörigen Programme, die Sendefrequenzen der die Programme abstrahlenden Sender und Senderidentifikationsgrößen, wie die vorstehend erwähnte Bereichskennung oder Zusatzinformation, abgespeichert sind. Alle im Senderspeicher 23 abgespeicherten Sender werden nacheinander von der Senderidentifikationsvorrichtung 21 aufgerufen und deren abgespeicherte Senderidentifikationsgrößen mit der Senderidentifikationsgröße des im Empfangsteil 19 momentan eingestellten Senders verglichen. Sobald Identität vorliegt, gibt die Senderidentifikationsvorrichtung 21 diejenige Adresse des Senderspeichers 23 aus, unter welcher der im Empfangsteil 19 empfangene und identifizierte Sender im Senderspeicher 23 abgespeichert ist. Diese Adresse wird als Senderbestimmungsgröße des gerade empfangenen Senders unter bestimmten Voraussetzungen, die noch nachfolgend beschrieben werden, in den Koppelspeicher 18 unter einer vorbestimmten Adresse eingeschrieben.

Erste Voraussetzung für das Einschreiben der Senderbestimmungsgröße in den Koppelspeicher 18 ist — wie eingangs bereits erwähnt — die Erfüllung des vorgegebenen Empfangskriteriums. Hier muß gewährleistet sein, daß die Empfangsfeldstärke des im Empfangsteil 19 eingestellten Senders größer ist als die Soll-Feldstärke $F_{Soll}$. Hierzu wird die im Empfangsteil 19 erfaßte Feldstärke des eingestellten Senders dem Feldstärkenvergleicher 22 zugeführt. Der Ausgang des Feldstärkenvergleichers 22 ist mit dem Steuereingang einer Torschaltung 24 verbunden, die zwischen dem Ausgang der Senderidentifikationsvorrichtung 21 und dem Dateneingang des Koppelspeichers 18 eingeschaltet ist. Ist die Feldstärke des gerade empfangenen Senders größer als die Soll-Feldstärke, so wird die Torschaltung 24 durchgeschaltet und die Senderbestimmungsgröße am Ausgang der Senderidentifikationsvorrichtung 21 liegt an dem Dateneingang des Koppelspeichers 18 an. Ist die Feldstärke des empfangenen Senders kleiner als die Soll-Feldstärke, so bleibt die Torschaltung 24 verriegelt und die von der Senderidentifikationsvorrichtung 21 ausgegebene Senderbestimmungsgröße wird blockiert.

An dem Ausgang der Torschaltung 24 ist ein Signaldetektor 25 angeschlossen, der dann ein Steuersignal ausgibt, sobald am Dateneingang des Koppelspeichers 18 eine Senderbestimmungsgröße ansteht. Der Ausgang des Signaldetektors 25 ist mit einem Lesebefehl-Auslöseeingang eines Steuerwerks 26 verbunden. Das an diesen Eingang des Steuerwerks 26 gelangende Steuersignal des Signaldetektors 25 bewirkt, daß das Steuerwerk 26 einen Lesebefehl ausgibt. Mit dem Lesebefehlausgang des Steuerwerks 26 ist einerseits der Steuerbefehleingang des Koppelspeichers 18 und andererseits der Steuerbefehleingang eines Leseadressierers 27 verbunden. Der Leseadressierer 27 ist mit den Adresseingängen des Koppelspeichers 18 verbunden. Zum Einschreiben der an dem Dateneingang des Koppelspeichers 18 anstehenden Senderbestimmungsgrößen ist ein Schreibadressierer 28 vorgesehen, dessen Ausgänge mit den Adresseingängen des Koppelspeichers 18 verbunden ist. Der Steuerbefehleingang des Schreibadressierers 28 ist mit einem Schreibbefehlausgang des Steuerwerks 26 verbunden. Der Leseadressierer 27 und der Schreibadressierer 28 können als einfache Zähler ausgebildet sein, deren Zählerstände jeweils die Adressen für den Koppelspeicher bilden. Der Leseadressierer 27 ist dabei als voreinstellbarer Zähler mit einem Reset-Eingang und einem Carry-Ausgang ausgebildet, dessen load-Adress-Eingang und dessen load-Beehl-Eingang jeweils mit dem Befehlsdecoder 17 verbunden sind. Der Reset-Eingang des Leseadressierers 27 ist mit einem Startimpuls-Ausgang des Steuerwerks 26 verbunden, der ebenfalls mit dem Eingang der Suchlaufautomatik 29 verbunden ist. An diesem Ausgang des Steuerwerks 26 tritt ein Startimpuls auf, der sowohl die Suchlaufautomatik 20 startet als auch den Leseadressierer 27 zurücksetzt. Zur Auslösung des Startimpulses weist das Steuerwerk 26 einen Startimpuls-Auslöseeingang auf, der mit dem Ausgang des Feldstärkenvergleichers 22 verbunden ist und immer dann ein Signal erhält, wenn die Feldstärke des im Empfangsteil 10 empfangenen Senders, die dem Feldstärkenvergleicher 22 zugeführt wird, kleiner ist als die vorgegebene Soll-Feldstärke. Der carry-Ausgang des Leseadressierers 27 ist mit einem Schreibbefehl-Auslöseeingang des Steuerwerks 26 verbunden. Zur Vermeidung des mehrmaligen Abspeicherns des gleichen Senders im Koppelspeicher 18 ist ein Koinzidenzprüfer 29 vorgesehen, der einerseits mit dem Dateneingang und andererseits mit dem Datenausgang des Koppelspeichers 18 verbunden ist. Der Koinzidenzprüfer 29 vergleicht die am Dateneingang des Koppelspeichers 18 zum Einschreiben anstehende Senderbestimmungsgröße sukzessive mit den bereits im Koppelspeicher 18 vorhandenen Senderbestimmungsgrößen und gibt bei Koinzidenz ein Steuersignal an den Startimpuls-Auslöseeingang des Steuerwerks 26.

Der Datenausgang des Koppelspeichers 18 ist mit dem Eingang eines Demultiplexers 30 verbunden. Die Ausgänge des Demultiplexers stehen jeweils mit einem der Programmanzeigeflächen 16 in Verbindung. Der Steuereingang des Demultiplexers 30 ist mit dem Adressausgang des Leseadressierers 27 verbunden. Dadurch ist den Anwahlgliedern 15 und den zugeordneten Speicherplätzen im Koppelspeicher 18 jeweils die gleiche Adresse zugehörig. Über den Demultiplexer wird die jeweils zugeordnete Programmanzeigefläche 16 mit einem Steuersignal belegt, das aus dem Speicherinhalt des unter der jeweiligen Adresse aufgerufenen Speicherplatzes im Koppelspeicher 18 abgeleitet ist. Dieses Steuersignal steuert eine Anzeigevorrichtung, die z. B. als 7-Segmentanzeige ausgebildet sein kann. Eine hier nicht dargestellte Decodierschaltung, die ebenfalls nicht dargestellten Anzeigevorrichtungen vorgeschaltet ist, wandelt die aus dem Koppelspeicher 18 jeweils ausgelesenen Senderbestimmungsgrößen in entsprechende Steuersignale zur lesbaren Anzeige der unter dieser Adresse abgespeicherten Sendeanstalt mit ihrem Sendeprogramm um. Eine ebenfalls nicht dargestellte Halteschaltung sorgt dafür, daß die Anzeige auch dann erhalten bleibt, wenn der Demultiplexer 30 auf den nächsten Ausgang umschaltet.

Die im Bedienfeld 14 in den Programmanzeigeflächen 16 angezeigten Sendeanstalten mit ihren Sendeprogrammen können durch Betätigen der Anwahlglieder 15 wahlweise eingestellt werden. Ein dieses Programm abstrahlender Sender wird im Empfangsteil 10 automatisch eingestellt und im Lautsprecher 13 hörbar. Hierzu ist der Suchlaufschaltung 11 eine Vergleichsstufe 31 vorgeschaltet, die einerseits mit dem Datenausgang des Senderspeichers 23 und andererseits mit dem Empfangsteil 10 verbunden ist. Die Vergleichsstufe 31 vergleicht die aus dem Senderspeicher 23 ausgelesene Sendefrequenz mit den in dem Empfangsteil 10 empfangenen Frequenzen und erzeugt ein Stopsignal für die Durchlaufautomatik 11, sobald die Frequenzen übereinstimmen. Damit ist der das ausgewählte Sendeprogramm abstrahlende Sender eingestellt und wird hörbar geschaltet.

Die Wirkungsweise des vorstehend beschriebenen Autoradios ist wie folgt :

Zu jedem beliebigen Standort des Autoradios sind in dem Koppelspeicher 18 Senderbestimmungsgrößen von im Beispiel fünf Sendern abgespeichert, die am Empfangsort empfangbar sind und jeweils ein verschiedenes Sendeprogramm abstrahlen. Die empfangbaren Sendeprogramme sind im Bedienfeld 14 auf den Programmanzeigeflächen 16 lesbar angezeigt. Der Bedienende kann nunmehr ein Sendeprogramm auswählen. Durch Drücken des der ausgewählten Programmanzeige zugeordneten Anwahlgliedes 15 wird das ausgewählte Sendeprogramm automatisch eingestellt und kann über den Lautsprecher 13 abgehört werden.

Hat der Bedienende z. B. die Sendeanstalt NDR und das Sendeprogramm 1 ausgewählt, so muß er im Bedienfeld 14 das zugeordnete Anwahlglied 15, das in der Reihenfolge von links nach rechts vierter Anwahlglied 15, betätigen. Der Befehlsdecoder 17 erhält ein codiertes Steuersignal, was charakteristisch für das vierte Anwahlglied 15 ist. Der Befehlsdecoder 17 gibt einen load-Befehl an den Leseadressierer 27 und ein Auslösesignal an den Lesebefehl-Auslöseeingang des Steuerwerks 26. Außerdem wird eine dem vierten Speicherplatz im Koppelspeicher 18 entsprechende Adresse an den load-Adress-Eingang des Leseadressierers 27 gegeben und in letzterem eingestellt. Das Steuerwerk 26 gibt über seinen Lesebefehlausgang einen Lesebefehl an den Koppelspeicher 18. Entsprechend der vom Leseadressierer 27 eingestellten Adresse wird die Senderbestimmungsgröße auf dem vierten Speicherplatz des Koppelspeichers aufgerufen und über den Datenausgang des Koppelspeichers 18 an den Adresseingang des Senderspeichers 23 gegeben. Aus dem Senderspeicher 23 wird unter der angelegten Adresse die dort abgelegte Sendefrequenz ausgelesen und an den einen Eingang der Vergleichsstufe 31 gelegt. Der Befehlsdecoder 17 gibt außerdem einen Startimpuls an die Durchlaufautomatik 11, die den Empfangsteil 10 solange durchstimmt, bis die empfangene Frequenz mit der ausgelesenen Frequenz übereinstimmt und die Vergleichsstufe 31 einen Stopimpuls an die Durchlaufautomatik 11 gibt. Das ausgewählte Sendeprogramm kann über den Lautsprecher 13 gehört werden.

Der Speicherinhalt des Koppelspeichers 18 wird laufend überwacht und je nach sich änderndem Standort des Autoradios laufend aktualisiert. Hierzu dient der zweite Empfangsteil 19 mit der Sendersuchlaufautomatik 20. Die Sendersuchlaufautomatik 20 wird von einem Startimpuls am Startimpuls-Ausgang des Steuerwerks 26 gestartet und sucht den ersten empfangbaren Sender auf. Von dem empfangenen Sender wird sowohl die Empfangsfeldstärke an den Feldstärkenvergleicher 22 als auch eine für den Sender charakteristische Identifikationsgröße an die Senderidentifikationsvorrichtung 21 gegeben. Wie bereits erwähnt, werden im Senderspeicher 23 abgespeicherte Senderidentifikationsgrößen, wie BK oder sonstige vom Sender ausgestrahlte Zusatzinformationen, nacheinander ausgelesen und der Senderidentifikationsvorrichtung 21 zugeführt und dort mit der vom Empfangsteil erhaltenen Senderidentifikationsgröße verglichen. Bei Koinzidenz gibt die Senderidentifikationsvorrichtung 21 die Adresse des Senderspeichers 23, unter welcher der identifizierte Sender abgespeichert ist, als Senderbestimmungsgröße an die Torschaltung 24. Im Feldstärkenvergleicher 22 wird geprüft, ob die Empfangsfeldstärke größer ist als die vorgegebene Soll-Feldstärke. Ist dies nicht der Fall, so gibt der Feldstärkenvergleicher 22 ein Steuersignal an den Startimpuls-Auslöseeingang des Steuerwerks 26, als Folge dessen das Steuerwerk 26 einen Startimpuls an die Suchlaufautomatik 20 gibt, die den nächsten empfangbaren Sender aufsucht. Der vorstehend beschriebene Vorgang wiederholt sich.

Ist die Feldstärke des empfangenen Senders größer als die Soll-Feldstärke, so gibt der Feldstärkenvergleicher 22 einen Toröffnungsimpuls an die Torschaltung 24. Die Senderbestimmungsgröße gelangt damit an den Dateneingang des Koppelspeichers 18. Die Senderbestimmungsgröße liegt gleichzeitig an dem einen Eingang des Koinzidenzprüfers 29 an. Gleichzeitig detektiert der Signaldetektor 25 eine Senderbestimmungsgröße am Dateneingang des Koppelspeichers 18 und gibt ein Steuersignal an den Lesebefehl-Auslöseeingang des Steuerwerks 26. Als Folge dessen gibt das Steuerwerk 26 einen Lesebefehl an den Koppelspeicher 18 und einen Enable-Befehl an den Leseadressierer 27. Letzterer beginnt schrittweise auf- oder abwärts zu zählen und sukzessive alle Speicherplätze des Koppelspeichers 18 zu adressieren. Die jeweils unter eine Adresse abgespeicherte Senderbestimmungsgröße des Koppelspeichers 18 wird über den Datenausgang dem Koinzidenzprüfer 29 und zugleich zur Anzeige in den Programmanzeigeflächen 16 dem Demultiplexer 30 zugeführt. Im Konzidenzprüfer 29 wird die ausgelesene Senderbestimmungsgröße mit der am Dateneingang des Koppelspeichers 18 anstehenden Senderbestimmungsgröße verglichen. Bei Koinzidenz gibt der Koinzidenzprüfer 29 ein Steuersignal an den Startimpuls-Auslöseeingang des Steuerwerks 26. Als Folge dessen erzeugt das Steuerwerk 26 einen Steuerbefehl, der als Startimpuls an der Suchlaufautomatik 20 und als Reset-Signal am Leseadressierer 27 liegt. Der Leseadressierer 27 wird zurückgesetzt und die Suchlaufautomatik 20 erneut gestartet und im Empfangsteil 19 der nächste empfangbare Sender aufgesucht.

Wird im Koinzidenzprüfer 29 nach Abarbeitung des gesamten Speicherinhalts des Koppelspeichers 18 kein Koinzidenzsignal erzeugt, so hat der Leseadressierer 27 seinen höchsten Zählerstand durchlaufen und am carry- oder Übertrag-Ausgang tritt ein Steuersignal auf, das an den Schreibbefehl-Auslöseeingang des Steuerwerks 26 gelangt. Als Folge dessen erzeugt das Steuerwerk 26 einen Schreibbefehl, der einerseits an dem Steuerbefehleingang des Koppelspeichers 18 und andererseits als Enable-Signal an dem Schreibadressierer 28 liegt. Der Schreibadressierer 28 adressiert den Koppelspeicher 18, und die am Dateneingang des Koppelspeichers 18 anliegenden Senderbestimmungsgröße wird in den adressierten Speicherplatz unter Überschreibung eines bereits evtl. vorhandenen Speicherinhalts eingeschrieben. Der Schreibadressierer 28 zählt die Anzsahl der erhaltenen Schreibbefehle und adressiert damit den Speicherplatz zum Neueinschreiben. Nach Überlauf setzt sich der Schreibadressierer 28 selbsttätig zurück, so daß wieder der erste Platz im Koppelspeicher 18 adressiert ist.

Die vorstehend beschriebenen Vorgänge wiederholen sich laufend, wobei im Empfangsteil 10 fortwährend empfangbare Sender aufgesucht werden und nach Identifikation, Qualitätskontrolle und Prüfen auf Vorhandensein im Koppelspeicher in letzterem abgelegt werden. Der Inhalt des Koppelspeichers 18 wird als Programmanzeige in den Programmanzeigeflächen 16 sichtbar gemacht. Ändert sich der Empfangsort des Autoradios, so ändern sich auch die mit optimaler Qualität empfangbaren Sender. Entsprechend den vorstehend beschriebenen Vorgängen wird der Speicherinhalt des Koppelspeichers 18 und damit die in dem Bedienfeld 18 sichtbaren Sendeprogramme laufend aktualisiert.

Die Erfindung ist nicht auf das beschriebene Ausführungsbeispiel beschränkt. So ist es nicht zwingend, daß die Senderbestimmungsgrößen die Adressen sind, unter welchen die Sender jeweils im Senderspeicher 23 abgelegt sind. So können die Senderbestimmungsgrößen, auch Codewörter sein, welche die Sendefrequenzen und ggf. die BK bzw. sonstige sendercharakteristische Zusatzinformationen enthalten. Dies hat den Vorteil, daß bei Auswahl eines im Bedienfeld angezeigten Programms die Sendefrequenz des zugehörigen Senders nicht über die im Koppelspeicher 18 abgespeicherte Adresse aus dem Senderspeicher 23 abgerufen werden muß, sondern direkt aus dem Koppelspeicher 18 dem Vergleicher 31 zugeführt werden kann.

## Patentansprüche

1. Ortsveränderlicher Rundfunkempfänger, wie Autoradio oder dergleichen, insbesondere UKW-Empfänger, mit einem Bedienfeld (14) für eine Programm-Direktwahl, das Programmanzeigeflächen (16) und diesen zugeordnete Anwahlglieder (15), vorzugsweise Tasten, zum Anwählen der angezeigten Programme aufweist, dadurch gekennzeichnet, daß die Programmanzeigeflächen (16) mit austauschbaren Programmanzeigen (NDR 2, WDR 1 etc.) belegbar sind und die Programmanzeigen (NDR 2, WDR 1 etc.) eine aktuelle Auswahl derjenigen Programme wiedergeben, die von vom Empfänger selbsttätig identifizierten Sendern abgestrahlt werden, deren Empfangsqualität am momentanen Empfängerstandort vorgegebenen Empfangskriterien, zum Beispiel einer vorbestimmten Empfangsfeldstärke, genügt.

2. Rundfunkempfänger nach Anspruch 1, dadurch gekennzeichnet, daß zur Zuordnung von Programmanzeigeflächen (16) und Anwahlgliedern (15) ein als Schreib-Lese-Speicher mit wahlfreiem Zugriff ausgebildeter Koppelspeicher (18) vorgesehen ist und daß jede Programmanzeigefläche (16) mit dem zugehörigen Anwahlglied (15) einem Speicherplatz des Koppelspeichers (18), vorzugsweise fest, zugeordnet ist.

3. Rundfunkempfänger nach Anspruch 2, dadurch gekennzeichnet, daß den Anwahlgliedern (15) und den zugeordneten Speicherplätzen im Koppelspeicher (18) jeweils die gleichen Adressen zugehörig sind und daß die den Anwahlgliedern (15) räumlich zugeordneten Programmanzeigeflächen (16) jeweils mit einem Steuersignal belegbar sind, das aus dem Speicherinhalt des unter der zugehörigen Adresse abgerufenen Speicherplatzes im Koppelspeicher (18) abgeleitet ist.

4. Rundfunkempfänger nach Anspruch 3, dadurch gekennzeichnet, daß zwischen Koppelspeicher (18) und Bedienfeld (14) ein Demultiplexer (30) eingeschaltet ist, dessen Eingang an dem Datenausgang des Koppelspeichers (18) angeschlossen ist und dessen Ausgänge jeweils mit einem der Programmanzeigeflächen (16) in Verbindung stehen, und daß ein Leseadressierer (27) vorgesehen ist, dessen Ausgang einerseits mit dem Adresseingang des Koppelspeichers (18) und andererseits mit dem Steuereingang des Demultiplexers (30) verbunden ist.

5. Rundfunkempfänger nach einem der Ansprüche 2-4, dadurch gekennzeichnet, daß im Koppelspeicher (18) Senderbestimmungsgrößen der Sender der aktuellen Programmauswahl, vorzugsweise willkürlich, abgespeichert sind.

6. Rundfunkempfänger nach Anspruch 5, mit einem Senderspeicher, in welchem Programme von Sendeanstalten, die Sendefrequenzen der die Programme abstrahlenden Sender und Senderidentifikationsgrößen zur eindeutigen Identifizierung der einzelnen Sender abgespeichert sind, dadurch gekennzeichnet, daß die Senderbestimmungsgrößen die Adressen des Senderspeichers (23) sind, unter welchen die Sender im Senderspeicher (23) jeweils auffindbar sind.

7. Rundfunkempfänger nach einem der Ansprüche 1-6, gekennzeichnet durch einen Empfangsteil (19) mit Sendersuchlaufautomatik (20) zum Auffinden empfangbarer Sender, durch eine Senderidentifikationsvorrichtung (21) zum Identifizieren des aufgefundenen Senders und durch eine Empfangsqualitäts-Kontrollvorrichtung (22) zum Prüfen der Empfangsqualität des aufgefundenen Senders.

8. Rundfunkempfänger nach einem der Ansprüche 2-7, dadurch gekennzeichnet, daß zur Vermeidung des mehrmaligen Abspeicherns des gleichen Senders im Koppelspeicher (18) eine den Speicherinhalt des Koppelspeichers (18) mit der Senderbestimmungsgröße eines aufgefundene Senders sukzessive vergleichenden Prüfvorrichtung (29) vorgesehen ist, die bei Koinzidenz eines Speicherwertes mit der anstehenden Senderbestimmungsgröße einen Startimpuls zum Aufsuchen des nächsten Senders auslöst.

### Claims

1. Mobile broadcast receiver, such as a car radio or similar, especially an FM receiver having an operating panel (14) for direct programme selection which is provided with programme display areas (16) and associated selection elements (15), preferably keys, for selecting the indicated programmes, characterised in that exchangable programme indications (NDR 2, WDR 1 etc.) can be allocated to the programme display areas (16) and the programme displays (NDR 2, WDR 1 etc.) reproduce a current selection of the programmes radiated by transmitters, which are automatically identified by the receiver and the quality of reception of which at the instantaneous site of the receiver meets predetermined reception criteria, for example a predetermined reception field strength.

2. Broadcast receiver according to Claim 1, characterised in that for the allocation of programme display areas (16) and selection elements (15), a coupling memory (18), which is constructed as a random-access read/write memory, is provided and that each programme display area (16) and its associated selection element (15) is preferably permanently associated with a storage space in the coupling memory (18).

3. Broadcast receiver according to Claim 2, characterised in that the selection elements (15) and the associated storage spaces in the coupling memory (18) are in each case associated with the same addresses and that the programme display areas (16), spatially associated with the selection elements (15), can be assigned in each case a control signal which is derived from the memory contents of the storage space, called up under the associated address, in the coupling memory (18).

4. Broadcast receiver according to Claim 3, characterised in that between the coupling memory (18) and the operating panel (14) a demultiplexer (30) is inserted, the input of which is connected to the data output of the coupling memory (18) and the outputs of which are in each case connected to one of the programme display areas (16) and that a read addressing circuit (27) is provided, the output of which is connected on the one hand to the address input of the coupling memory (18) and on the other hand to the control input of the demultiplexer (30).

5. Broadcast receiver according to one of Claims 2-4, characterised in that transmitter-determining quantities of the transmitters of the current programme selection are stored, preferably arbitrarily, in the coupling memory (18).

6. Broadcast receiver according to Claim 5, containing a transmitter memory in which programmes of broadcasting institutions, the broadcasting frequencies of the transmitters radiating the programmes and transmitter identification quantities for the unambiguous identification of individual transmitters are stored, characterised in that the transmitter-determining quantities are the addresses of the transmitter memory (23) at which the transmitters can be found in each case in the transmitter memory (23).

7. Broadcast receiver according to one of Claims 1-6, characterised by a receiving section (19) comprising an automatic transmitter search circuit (20) for finding receivable transmitters, by a transmitter identification device (21) for identifying the transmitter found and by a device (22) for controlling the quality of reception for checking the quality of reception of the transmitter found.

8. Broadcast receiver according to one of Claims 2-7, characterised in that, to prevent multiple storage of the same transmitter in the coupling memory (18), a checking device (29) is provided which successively compares the memory contents of the coupling memory (18) with the transmitter-determining quantity of a transmitter found and which on coincidence of a stored value with the transmitter-determining quantity present triggers a pulse for starting the search for the next transmitter.

### Revendications

1. Récepteur-radio mobile tel qu'un auto-radio ou analogue notamment un récepteur MF, ayant une zone de commande (14) pour le choix direct d'un programme, qui comporte des surfaces d'affichage de programme (16) et des éléments de sélection (15) correspondants, de préférence des touches pour sélectionner les programmes affichés, caractérisé en ce que les surfaces d'affichage de programme (16) peuvent être occupées par des indications de programme variables (NDR 2, WDR 1 etc.) et les indications de programme (NDR 2, WDR 1 etc.) représentent une sélection réelle de ces programmes qui sont émis par les émetteurs identifiés automatiquement par le récepteur et dont la qualité de réception satisfait aux critères de réception, prédéterminés, à l'endroit instantané où se trouve le récepteur, par exemple à une intensité prédéterminée du champ.

2. Récepteur-radio selon la revendication 1, caractérisé en ce que pour l'association de surfaces d'affichage de programme (16) et d'éléments de sélection (15), il est prévu une mémoire de couplage (18) réalisée sous la forme d'une mémoire d'écriture et de lecture avec accès sélectif et en ce que chaque surface d'affichage de programme (16) est associée à l'élément de sélection (15), correspondant d'un emplacement de la mémoire de couplage (18), de préférence de façon définitive.

3. Récepteur-radio selon la revendication 2, caractérisé en ce que les mêmes adresses appartiennent aux éléments de sélection (15) et aux emplacements correspondants de la mémoire de couplage (18) et en ce que les surfaces d'affichage de programme (16) qui sont associées géométriquement aux éléments de sélection (15) peuvent être chaque fois occupées par un signal de commande qui est dérivé du contenu de l'emplacement de la mémoire de couplage (18) qui se trouve à l'adresse correspondante.

4. Récepteur-radio selon la revendication 3, caractérisé en ce qu'un démultiplexeur (30) est prévu entre la mémoire de couplage (18) et la zone de commande (14), démultiplexeur dont l'entrée est reliée à la sortie des données de la mémoire de couplage (18) et dont les sorties sont respectivement reliées à l'une des surfaces d'affichage de programme (16) et en ce qu'il est prévu un dispositif d'adressage de lecture (27) dont la sortie est reliée d'une part à l'entrée d'adresses de la mémoire de couplage (18) et d'autre part à l'entrée de commande du démultiplexeur (30).

5. Récepteur-radio selon l'une quelconque des revendications 2 à 4, caractérisé en ce que la mémoire de couplage (18) contient des grandeurs caractéristiques des émetteurs de la sélection de programme réelle de préférence arbitraire.

6. Récepteur-radio selon la revendication 5 comportant une mémoire d'émetteurs qui contient les programmes des émetteurs, les fréquences d'émission des émetteurs émettant les programmes et des grandeurs d'identification des émetteurs pour identifier sans équivoque les différents émetteurs, caractérisé en ce que les grandeurs caractéristiques des émetteurs sont les adresses de la mémoire d'émetteurs (23) sous lesquelles peuvent se trouver chaque fois les émetteurs dans la mémoire d'émetteurs (23).

7. Récepteur-radio selon l'une des revendications 1 à 6, caractérisé par une partie-récepteur (19) avec un dispositif de recherche automatique (20) pour rechercher les émetteurs susceptibles d'être reçus, un dispositif d'identification d'émetteurs (21) pour identifier l'émetteur trouvé et par un dispositif de contrôle de qualité de réception (22) pour contrôler la qualité de réception de l'émetteur trouvé.

8. Récepteur-radio selon l'une des revendications 2 à 7, caractérisé en ce que pour éviter d'enregistrer plusieurs fois le même émetteur dans la mémoire de couplage (18), il est prévu un dispositif de contrôle (29) qui compare successivement une grandeur caractéristique d'émetteur du contenu de la mémoire de couplage (18) et la grandeur caractéristique de l'émetteur trouvé, et lors de la coïncidence de la valeur de l'émetteur et de la grandeur caractéristique de l'émetteur trouvé, ce dispositif émet une impulsion de démarrage pour rechercher l'émetteur suivant.

0 095 564